# EUROPÄISCHE PATENTSCHRIFT

(11) **EP 0 504 656 B1**
(45) Veröffentlichungstag und Bekanntmachung des Hinweises auf die Patenterteilung: **24.07.1996**
(21) Anmeldenummer: 92103656.2
(22) Anmeldetag: 04.03.1992
(51) Int. Cl.: B05C 9/04, B05C 13/02, H05K 13/00, H05K 3/00

(54) **Verfahren und Vorrichtung zum einseitigen Behandeln von plattenförmigen Gegenständen**
Method and device for treating one side of plate-like articles
Méthode et dispositif pour le traitement d'un côté de produits en plaque

(30) Priorität: 08.03.1991 DE 4107464
(43) Veröffentlichungstag der Anmeldung: 23.09.1992
(73) Patentinhaber: Gebr. Schmid GmbH & Co., D-72250 Freudenstadt (DE)
(72) Erfinder: Schmid, Dieter C., W-7290 Freudenstadt (DE)
(74) Vertreter: Patentanwälte Ruff, Beier, Schöndorf und Mütschele

(56) Entgegenhaltungen:
- DE-A- 3 047 578
- US-A- 3 610 397
- US-A- 4 949 665

## Beschreibung

Die Erfindung betrifft ein Verfahren und eine Vorrichtung nach den Oberbegriffen der Ansprüche 1, 2 und 10.

Aus der US-A-3 610 397 geht ein Verfahren und eine Vorrichtung zum Wenden einer Platte hervor, die in Sprühbeschichtungsarbeitsgängen einsetzbar sind. Dabei werden die zu beschichtenden Platten auf Ketten liegend horizontal durch eine Sprühbeschichtungsstation geführt, in der sie durch eine oben liegende Spraydüse an ihrer Oberseite beschichtet werden. Sie laufen dann in eine Wendestation ein, die die Platten zwischen seitlichen Backen faßt und umdreht. Sie kommt dann auf den gleichen Kettenförderer wieder in umgekehrter Lage zu liegen und wird durch eine zweite Behandlungskammer geführt, wo ebenfalls eine Beschichtung von oben her stattfindet.

Die US-A-4 949 665 beschreibt eine solche Beschichtungsvorrichtung, bei der eine Wendestation nur einer Beschichtungsvorrichtung zugeordnet ist, die die zu beschichtende Platte nach dem Wenden rückwärts durchläuft.

Aus den EP-A-18 00 78, GB-A-20 98 510, IBM Technical Disclosure Bulletin, Vol. 32, No. 1, June 1989, Seiten 311-313 und IBM Technical Disclosure Bulletin, Vo. 10, No. 5, Oktober 1967, Seiten 528-529, sind Vorrichtung bekanntgeworden, mit denen eine Platte mit einem Fotoresist beschichtet werden kann. Die Platte wird dazu durch eine wegen der hochviskosen Konsistenz des aufzubringenden Mediums möglichen hochgewölbten Flüssigkeitsspiegel bewegt.

Bei anderen bisher bekannten Verfahren wurden die Leiterplatten nach einer einseitigen Behandlung zum Eingang der Behandlungsvorrichtung zurückgeführt und erneut, diesmal in gewendetem Zustand, in die Behandlungsvorrichtung eingespeist.

Ein solches Verfahren fügt sich nicht in eine auf ein horizontales kontinuierliches Durchlaufverfahren ausgerichtete Produktionslinie ein, da sie durch die Kreislaufführung der Platten zur Unterbrechung der Produktionslinie führt.

Aufgabe der vorliegenden Erfindung ist es, die eingangs beschriebene Vorrichtung derart weiterzubilden, daß sich diese in einen kontinuierlich laufenden horizontalen Produktionsprozeß einfügen läßt.

Diese Aufgabe wird durch das Verfahren nach den Ansprüchen 1 und 2 gelöst.

Als weitere Behandlungsstation kann sich eine zweite Behandlungsstation direkt anschließend an die Behandlungsstation eignen. Es ist aber auch möglich, die erste Behandlungsstation als weitere Behandlungsstation zu nutzen, wobei dann die Platten nach dem Wenden der ersten Behandlungsstation in entgegengesetzter Richtung zur allgemeinen Transportrichtung der Behandlungsvorrichtung zugeführt werden.

In diesem Falle werden die Platten also nicht zum Eingangsbereich der ersten Behandlungsstation zurückgeführt, sondern direkt von der Wendevorrichtung in die erste Behandlungsstation zurückgegeben.

Um die Anlage in einen kontinuierlichen Prozeß einzufügen, muß in diesem Falle nur sichergestellt werden, daß die Platten in solchen zeitlichen Abständen der Behandlungsvorrichtung zugeführt werden, daß eine vollständige Behandlung, d.h. eine Behandlung der Ober- und der Unterseite in der ersten Behandlungsstation einer Platte erfolgen kann, bevor die nächste Platte der Behandlungsvorrichtung zugeführt wird.

Ein größerer Durchsatz von Platten pro Zeiteinheit wird selbstverständlich dann erzielt, wenn sich an die Wendevorrichtung eine zweite Behandlungsstation, die der ersten Behandlungsstation entspricht, anschließt. In diesem Falle können die Platten in kleinen Zeitabständen der Behandlungsvorrichtung zugeführt werden.

Das Verfahren, bei dem die erste Behandlungsstation auch als weitere Behandlungsstation verwendet wird, schafft allerdings die Möglichkeit, die Behandlungsvorrichtung auf sehr kleinem Raum unterzubringen, weshalb diese Lösung bei beengten Platzverhältnissen bei verminderter Taktzahl an Platten pro Zeiteinheit eingesetzt wird.

Normalerweise werden die Platten mittels der Wendevorrichtung um eine Achse gedreht, welche parallel zur Transportebene und senkrecht zur Transportrichtung angeordnet ist. In Transportrichtung der Platten gesehen wird die Drehachse der Wendevorrichtung etwa mittig in der Wendevorrichtung angeordnet.

Im Zuge der neueren Entwicklung der Leiterplattentechnik geschieht es jedoch häufiger, daß gewisse Vorzugsrichtungen der Laufrichtungen der auf den Oberflächen aufgebrachten Leiterbahnen existieren, welche an der Oberseite und Unterseite der Platte verschieden sind und einen Winkel von 90° zueinander bilden.

Da die Laufrichtung der Leiterbahnen bei dem Aufbringen des flüssigen Mediums vorzugsweise zu berücksichtigen ist, wird bei einer Ausführungsform der Erfindung die Drehachse der Wendevorrichtung parallel zur Transportebene angeordnet sein, jedoch einen Winkel von 45° mit der Transportrichtung bilden.

Durch diese Maßnahme wird erreicht, daß gleichzeitig mit dem Drehen der Platten, wobei die Unterseite in die Oberlage gelangt, eine Drehung der Platten in der Transportebene um 90° erzielt wird. Damit werden die Platten in einer optimalen Ausrichtung der weiteren Behandlungsstation zugeführt, die jetzt eine identische Anordnung der Vorrichtung zum Bespülen bzw. Besprühen der Unterseite wie die erste Behandlungsstation haben kann. Dies bedeutet gleichzeitig, daß auch im Falle, daß die gewendeten Platten der ersten Behandlungsstation in entgegengesetzter Richtung zur allgemeinen Transportrichtung zugeführt werden, eine optimale Behandlung der ehemals oben liegenden Seite der Platte erfolgt.

Vorzugsweise werden die oben liegenden Plattenseiten im ersten und im dritten Schritt jeweils im wesentlichen vollständig abgedeckt, so daß das flüssige Behandlungsmedium nicht zutreten kann.

Hierdurch wird sichergestellt, daß die Behandlungsergebnisse gleichmäßig sind und daß keine Nachbehandlung der jeweils oben liegenden Plattenseite erfolgt, die unerwünscht ist.

Bei beengten Raumverhältnissen kann auch vorgesehen sein, daß die Platten beim Transport durch die Behandlungsvorrichtung im Bereich der ersten und der weiteren Behandlungsstation während dem eigentlichen Behandlungsschritt angehalten oder verlangsamt transportiert werden und daß die Platten nach der Behandlung in der ersten und weiteren Behandlungsstation mit der ursprünglichen Geschwindigkeit weitertransportiert werden.

Da die Behandlungszeiten der Oberflächen der Platten in der Regel von Reaktionsgeschwindigkeiten, Diffusionsprozessen und ähnlichem abhängen, die den Fortschritt der Behandlung der jeweiligen Plattenseite bestimmen und die ohne Änderung des Behandlungsmediums oder einer Änderung des Aufbaus der Platte nicht verändert werden können, läßt sich auf diese Weise bei sonst unverändertem Behandlungsprozeß eine kompaktere Ausbildung der Behandlungsvorrichtung insgesamt erreichen. Die Zeitdauer, die die Platten in der jeweiligen Behandlungsstation verbringen, bleibt damit im wesentlichen dieselbe, wobei jedoch der Transportweg bzw. die Ausdehnung der Behandlungsstation in Transportrichtung wesentlich kleiner gehalten werden kann als üblich. Eine noch kompaktere Lösung ist dann zu erreichen, wenn hier die erste Behandlungsstation auch als weitere Behandlungsstation genutzt wird, wobei dann die Platten wiederum entgegen der allgemeinen Transportrichtung der Behandlungsvorrichtung in die erste Behandlungsstation zur Durchführung des dritten Schrittes zurückgefördert werden.

Das flüssige Medium wird gegen die unten liegende Seite der Platte vorzugsweise in Form eines Flüssigkeitsschwalles gefördert, der eine großflächige, intensive Benetzung der Unterseite der Platte sicherstellt.

Ergänzend oder alternativ hierzu kann das flüssige Medium auch mittels einer Vielzahl von Sprüh- und/oder Vernebelungsdüsen gegen die unten liegende Seite der Platte gefördert werden. Die Wahl der Vorrichtung zum Fördern des flüssigen Mediums gegen die unten liegende Seite der Platte hängt von dem jeweils durchzuführenden Prozeß ab und dem für den Prozeß geforderten Benetzungsgrad bzw. der dabei notwendigen Intensität des Flüssigkeitsaustausches.

Während bei einem normalen Durchlaufverfahren die Fördermittel, die das flüssige Medium gegen die unten liegende Seite der Platte fördern, im wesentlichen ortsfest angeordnet werden können, kann im Fall, daß die Transportgeschwindigkeit in der Behandlungsstation abgesenkt wird oder die Platten gar angehalten werden, vorgesehen sein, daß die Fördermittel gegenüber der Platte bzw. gegenüber der umgebenden Behandlungsstation so bewegt werden, daß sich eine gleichmäßige Behandlung der Plattenunterseite über deren ganze Fläche ergibt.

Vorzugsweise wird die jeweilige Position der Platten auf dem Transportweg durch die Behandlungsvorrichtung mittels Sensoren erfaßt.

Insbesondere im Bereich der Wendevorrichtung sollte ein Sensor angeordnet werden, der das Eintreten der rückwärtigen Plattenkante in die Wendevorrichtung erfaßt. Dieses Signal läßt sich dann dazu nutzen, die Transportmittel der Wendevorrichtung in dem Augenblick stillzusetzen, in dem die Platte vollständig in die Wendevorrichtung eingetreten ist. Bei einem nachfolgenden Verschwenken der Platte ist die ehemals rückwärtige Plattenkante als vordere Kante direkt benachbart zu der nachfolgenden Behandlungsstation angeordnet, so daß das Wenden der Platte gleichzeitig mit einem Transport der Platte in Richtung zur weiteren oder zweiten Behandlungsstation hin verbunden ist. Damit kann der Vorgang zwischen den beiden Behandlungsstationen bzw. den beiden Behandlungsschritten vom Zeitbedarf her minimiert werden.

Bisher bekannte Vorrichtungen zur Durchführung eines Verfahrens der eingangs beschriebenen Art umfassen eine Transportvorrichtung für den horizontalen Transport der Platten durch die Vorrichtung, eine Behandlungsstation zur Behandlung einer unten liegenden Seite der Platten mit einem flüssigen Medium und eine Wendevorrichtung zum Drehen der Platten mit ihrer unten liegenden Seite in die Oberlage.

Eine weitere Aufgabe der Erfindung ist es, diese Behandlungsvorrichtung derart weiterzubilden, daß sie für das erfindungsgemäße Behandlungsverfahren geeignet ist.

Diese Aufgabe wird durch die Vorrichtung nach Anspruch 10 gelöst.

Mit diesen zusätzlichen Merkmalen der Behandlungsvorrichtung wird sichergestellt, daß die Platten der Wendevorrichtung horizontal übergeben werden können und daß die Platten auch nach dem Wenden unmittelbar wieder an eine Behandlungsstation abgegeben werden können.

Bevorzugt werden die Transportvorrichtung und die Transportmittel eine gemeinsame Transportebene bilden.

Bevorzugt werden die Transportmittel der Wendevorrichtung so ausgebildet, daß die Platten während des Drehvorgangs ortsfest durch die Transportmittel fixiert sind. Dies erübrigt eine zusätzliche Haltevorrichtung, die die Platten beim Drehen in der Wendevorrichtung haltern.

Es kann vorgesehen sein, daß eine Drehachse für die Drehbewegung der Platte in der Transportebene der Transportmittel und senkrecht zur Transportrichtung angeordnet ist. In diesem Fall wird die Unterseite der Platte in die Oberlage gedreht, und die ehemals rückwärtige Kante wird zur in Transportrichtung vorne liegenden Kante der Platte.

Alternativ oder zusätzlich kann vorgesehen sein, daß eine Drehachse für die Drehbewegung der Platten vorhanden ist, die in der Transportebene der Transportmittel und in einem Winkel von 45° zur Transportrichtung angeordnet ist.

Wird eine Drehung um diese Achse durchgeführt, so wird zusätzlich zu der Drehung der Unterseite der Platte in die Oberlage eine Rotation der Platte um 90° erreicht, weshalb jetzt als vordere Plattenkante eine frühere Seitenkante fungiert.

Bei einer bevorzugten Ausführungsform der Erfindung ist eine Vorrichtung zum Erfassen einer Vorzugsrichtung auf einer der Oberflächen der Platten vorgesehen, wobei dann die Drehachse für die Drehbewegung der Platten in Abhängigkeit von der erfaßten Vorzugsrichtung ausgewählt wird.

Die Vorrichtung zum Erfassen der Vorzugsrichtung kann eine Vorrichtung zum Abtasten von auf der Plattenoberseite befindlichen maschinenlesbaren Informationen sein oder auch schlicht eine Schnittstelle zu der Anlagensteuerung insgesamt, über die die Informationen über die Vorzugsrichtung der betreffenden Plattenseite übermittelt werden.

Die Vorzugsrichtung einer Oberfläche der Platte richtet sich danach, wie die Leiterbahnen der Leiterplatte überwiegend ausgerichtet sind, da dies bei der Behandlung der Leiterplatten das Behandlungsergebnis sehr stark beeinflußt. Dies gilt insbesondere im Falle, daß die Leiterbahnen sehr geringe Abmessungen aufweisen, wie dies immer häufiger aufgrund der ansteigenden Integrationsdichte der auf den Leiterbahnen aufzubringenden elektronischen Bausteine der Fall ist.

Bevorzugt wird die Wendevorrichtung einen Sensor zum Erfassen der rückwärtigen Kante der in die Wendevorrichtung einlaufenden Platte umfassen, damit so sofort nach vollständigem Einlaufen der Platte in die Wendevorrichtung deren Transportmittel stillgesetzt werden können, so daß nach einem Drehen der Wendevorrichtung die rückwärtige Kante, die jetzt als vordere Kante der Platte erscheint, in direkter Nachbarschaft zu der nachfolgenden Behandlungsstation angeordnet ist.

Bevorzugt wird die Transportvorrichtung oberhalb der Transportebene ein umlaufendes Endlosband umfassen, wobei das Untertrum des Bandes die Oberseite der Platten belegt. Um zu verhindern, daß die Oberseite der Platten während der Behandlung der Unterseite mit dem flüssigen Medium in Berührung kommt, wird vorzugsweise das Band so ausgelegt, daß es im wesentlichen vollständig und flüssigkeitsdicht die Oberseite der Platten bedeckt.

Eine besonders einfach Lösung zum Haltern der Platten innerhalb der Wendevorrichtung ist darin zu sehen, daß die Transportmittel der Wendevorrichtung oberhalb und unterhalb der Transportebene jeweils ein endlos umlaufendes Band umfassen. Die Platten werden innerhalb der Wendevorrichtung dann durch das Unter- bzw. Obertrum der beiden endlos umlaufenden Bänder erfaßt und ortsfest gehalten. Hier reicht ein Stillsetzen der Transportmittel der Wendevorrichtung aus, um die Platte in einer bestimmten Position innerhalb der Wendevorrichtung für den Drehvorgang zu fixieren.

Das Endlosband der Behandlungsstation und auch die Endlosbänder der Transportmittel der Wendevorrichtung weisen im wesentlichen eine Breite auf, die der gesamten Arbeitsbreite der Vorrichtung entspricht.

Zur einfacheren Wartung der Behandlungsvorrichtung kann vorgesehen sein, daß die oberhalb der Transportebene angeordneten Teile der Transportvorrichtung als Ganzes verschwenkbar an der Vorrichtung gehalten sind.

Eine der bevorzugten Verschwenkachsen für den oberen Teil der Transportvorrichtung liegt parallel zur Transportebene und senkrecht zur Transportrichtung.

Eine Alternative hierzu wäre die Anordnung der Verschwenkachse parallel zur Transportrichtung und parallel zur Transportebene, wobei dann vorgesehen sein sollte, daß die Verschwenkachse außerhalb des normalen Arbeitsbereichs der Behandlungsstationen liegt.

Im Falle, daß mehrere Behandlungsstationen mit demselben flüssigen Medium betrieben werden, ist vorzugsweise vorgesehen, daß mindestens zwei der Behandlungsstationen aus einem gemeinsamen Sumpf mit dem flüssigen Medium versorgt werden.

Die Behandlungsstation selbst kann einen Düsenstock mit einer Vielzahl von Düsen umfassen, die für die Sprühbehandlung oder Vernebelungsbehandlung der Unterseite der Platte ausgelegt ist. Bei der Anordnung der Düsen am Düsenstock wird darauf geachtet, daß sich ein gleichmäßiges Sprühmuster ergibt, so daß der Behandlungserfolg an der Unterseite der Platte an jeder Stelle vergleichbar mit den Nachbarbereichen ist.

Eine noch gleichmäßigere Beaufschlagung der Unterseite der Platte mit dem flüssigen Medium wird dann erreicht, wenn der Düsenstock gegenüber den in der Behandlungsstation befindlichen Platten bewegbar ausgelegt ist. Diese Bewegungsmöglichkeit des Düsenstockes kann dazu führen, daß es ausreichend ist, die Platte in der Behandlungsstation ortsfest anzuordnen und nur den Düsenstock gegenüber der Platte zu bewegen oder aber die Platte mit sehr langsamer Vorschubgeschwindigkeit durch die Behandlungsstation zu bewegen, ohne daß dabei die Qualität des Behandlungsergebnisses beeinträchtigt wird.

Anstelle oder ergänzend zu dem Düsenstock kann auch eine Schwallstrecke vorgesehen sein, die entweder ortsfest oder im Falle daß die Platten im wesentlichen stationär behandelt werden sollen, über die Behandlungsposition der Platte verfahrbar angeordnet ist.

In einer bevorzugten Konfiguration der Behandlungsvorrichtung ist vorgesehen, daß nachfolgend zur ersten Behandlungsstation unmittelbar die Wendevorrichtung und danach in Transportrichtung gesehen unmittelbar anschließend die weitere, zweite Behandlungsstation sowie ein Reinigungs- oder Spülmodul angeordnet sind.

Im Falle daß die Behandlungsvorrichtung bei beengten Platzverhältnissen aufgestellt werden muß, wird vorgesehen, daß nachfolgend zur ersten Behandlungsstation unmittelbar die Wendevorrichtung und danach in Transportrichtung unmittelbar anschließend ein Reinigungs- oder Spülmodul angeordnet angeordnet sind. Die erste Behandlungsstation wird dabei als weitere Behandlungsstation verwendet, wobei die Platten von der Wendevorrichtung nach dem Wenden entgegen der allgemeinen Transportrichtung der Behandlungsvorrichtung in die erste Behandlungsstation zurücktransportiert werden.

Diese und weitere Vorteile der Erfindung werden im folgenden anhand der Zeichnung noch näher erläutert. Es zeigen im einzelnen:
- Fig. 1: eine teilweise aufgebrochene Seitenansicht einer erfindungsgemäßen Behandlungsvorrichtung;
- Fig. 2a, b, c: Alternativen der Drehachse für eine erfindungsgemäße Wendevorrichtung.

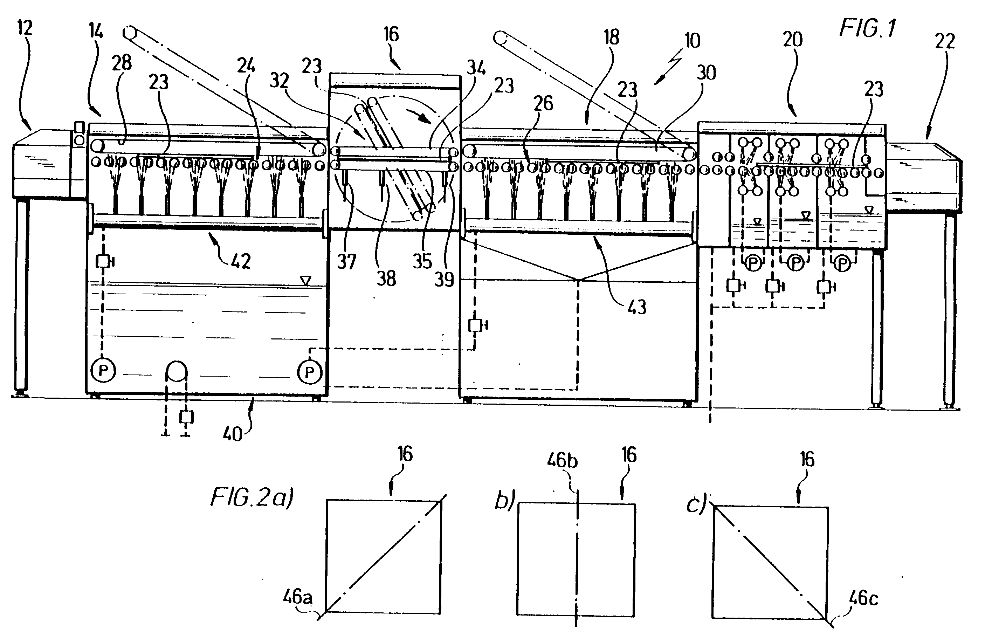

Die in Fig. 1 abgebildete, insgesamt mit dem Bezugszeichen 10 bezeichnete Behandlungsvorrichtung ist modular aufgebaut und umfaßt dabei neben einer Einlaufstation 12, einer ersten Behandlungsstation 14, einer Wendevorrichtung 16, einer zweiten Behandlungsstation 18 ein Spülmodul 20 sowie einen Auslauf 22.

Innerhalb der Gesamtvorrichtung 10 wird eine Transportebene durch die Transportrollensysteme 24, 26 definiert, welche vom Einlauf 12 durch die erste Behandlungsstation 14, unterbrochen von der Wendevorrichtung 14 über die zweite Behandlungsstation 18 und das Spülmodul 20 zum Auslauf 22 führen.

Oberhalb der durch die Transportrollensysteme 24 und 26 gebildeten Transportebene sind im Bereich der ersten und der zweiten Behandlungsstation 14, 18 umlaufende Endlosbänder 28, 30 angeordnet, welche mitsamt ihrer Führung parallel zur Transportrichtung der Platten nach oben verschwenkbar sind. Die Verschwenkachse liegt dabei parallel zur Transportebene und senkrecht zur Transportrichtung, und mit dem Verschwenken der Bandsysteme wird im wesentlichen der gesamte Bereich der Transportrollensysteme 24, 26 für die Wartung frei zugänglich.

Die Endlosbänder haben bei der erfindungsgemäßen Vorrichtung die Funktion, die oben liegende Seite der Leiterplatten 23 abzudecken, so daß diese Seite nicht mehr von dem von unten zugeführten flüssigen Behandlungsmedium, insbesondere den bei den Ätzvorgängen verwendeten Ätzmitteln benetzt werden kann. Ein unerwünschtes Nachätzen oder Vorätzen der oben liegenden Leiterplattenseiten läßt sich somit zuverlässig unterbinden.

Die Lücke zwischen den Transportrollensystemen 24 und 26 wird durch die Transportmittel 32 der Wendevorrichtung 16 überbrückt, welche in ihrer Ausgangsstellung die Transportebene der Transportrollensysteme 24 und 26 koplanar miteinander verbinden.

Das Transportmittel 32 der Wendevorrichtung 16 besteht im wesentlichen aus zwei gegenläufig antreibbaren Endlosbändern 34, 35, welche zwischen dem Obertrum und dem Untertrum die Leiterplatten 23 halten, wenn diese im Bereich der Wendevorrichtung 16 angelangt sind.

Sensoren 37, 38, 39 überwachen die relative Stellung der Leiterplatten innerhalb der Wendevorrichtung 16.

Das Spülmodul 20 schließt sich an die zweite Bearbeitungsstation 18 an. Hier werden die Leiterplatten von dem noch anhaftenden Behandlungsmedium befreit, und da hier kein kritischer Prozeß vorliegt, findet hier die Bespülung der Oberflächen mit einer Reinigungsflüssigkeit, vorzugsweise Wasser, beidseitig statt.

Wie aus Figur 1 ersichtlich, benutzen die erste und die zweite Behandlungsstation ein gemeinsames Auffanggefäß 40, welches einen Vorrat an Behandlungsflüssigkeit für beide Auftragsysteme enthält. Die Behandlungsflüssigkeit wird über Düsensysteme 42, 43, die eine Vielzahl gleichmäßig verteilter Sprühdüsen in einem Rahmen gehalten umfassen, gegen die Unterseite der Leiterplatten gefördert.

Bevorzugt werden die Rahmen der Düsensysteme ausziehbar ausgestaltet, so daß sich eine Wartung der Sprühdüsen bei aus der Behandlungsstation herausgezogenem Düsenstock leicht durchführen läßt.

Figur 2 zeigt die drei bevorzugten Varianten der Ausrichtung der Drehachse 46 a, b, c der Wendevorrichtung 16. Die Wendevorrichtung selbst ist in den Figuren 2 a, b, c nur schematisch dargestellt.

Beim Betrieb der Gesamtvorrichtung läuft die Leiterplatte 23 über den Einlauf in die erste Behandlungsstation 14 ein und wird über das Transportrollensystem 24 in Richtung zur Wendevorrichtung 16 weitertransportiert. In der Behandlungsstation 14 wird die unten liegende Seite der Platte 23 mit dem flüssigen Behandlungsmedium besprüht, wobei es sich hierbei z.B. um einen Ätzvorgang, ein Anquellen eines Fotoresistlackes usw. handeln kann. Die Transportstrecke innerhalb der Behandlungsstation 14 ist so bemessen, daß zusammen mit der gewählten Transportgeschwindigkeit eine ausreichend lange Aufenthaltszeit in der Behandlungsstation für den jeweiligen Behandlungsschritt gewährleistet ist.

Beim Einlauf der Platte in die Wendestation 16 erfaßt der Sensor 37 das Einlaufen der rückwärtigen Kante der Platte 23 in die Wendevorrichtung und gibt ein Signal an die Steuerung der Gesamtvorrichtung ab. Durch die Steuerung werden in diesem Augenblick die Transportmittel 32 der Wendevorrichtung 16, d.h. die beiden Endlosbänder 34, 35 abgestoppt und der Drehvorgang der Wendevorrichtung 16 wird eingeleitet.

Falls die Leiterplatte 23 an der zunächst unten liegenden Seite und der zunächst oben liegenden Seite unterschiedliche Vorzugsrichtungen der Leiterbahnen aufweist, wird die Platte 23 in der Wendevorrichtung 16 vorzugsweise um eine Drehachse wie die Drehachsen 46 a und 46 c (vgl. Figur 2 a und c) gedreht und nicht um eine Drehachse 46 b, wie dies in Figur 2 b angegeben ist.

Dadurch findet während der Drehung der Platte mit dem Tausch von Ober- und Unterseite gleichzeitig eine Drehung "in der Plattenebene" um 90° statt, so daß die Vorzugsrichtung der Leiterbahnen im nachfolgenden Behandlungsschritt optimal dem Sprühmuster der Behandlungsstation 18 angepaßt ist.

Dadurch, daß die Platte sofort nach Eintreten der rückwärtigen Kante in die Wendevorrichtung 16 abgestoppt wird, befindet sich die nun vordere Kante der Leiterplatte in nächster Nähe zur Behandlungsstation 18, d.h. durch den Drehvorgang in der Wendevorrichtung 16 findet gleichzeitig ein Transport der Leiterplatte in Richtung zur zweiten Behandlungsstation hin statt. Die Transportmittel 32 der Wendevorrichtung 16 werden während der Drehbewegung deshalb stillgesetzt.

Nach Ausführung der Drehbewegung durch die Wendevorrichtung 16 wird die Leiterplatte nachfolgend direkt an die zweite Behandlungsstation 18 übergeben, in der nun die zunächst oben liegende Seite durch die von unten aufgesprühten flüssigen Medien behandelt wird.

In der nachfolgenden Station 20 werden die Leiterplatten von Resten des Behandlungsmediums befreit und gegebenenfalls zusätzlich getrocknet und verlassen über den Auslauf 22 die Gesamtvorrichtung.

## Patentansprüche

1. Verfahren zum Behandeln von plattenförmigen Gegenständen mit einem flüssigen Medium,
wobei die Platten (23) in horizontaler Lage durch eine Behandlungsvorrichtung (10) hindurch transportiert werden,
wobei die Platten (23) in einem ersten Schritt in einer ersten Behandlungsstation (14) auf einer Seite mit dem flüssigen Medium behandelt werden,
wobei die Platten (23) in einem zweiten Schritt horizontal einer Wendevorrichtung (16) zugeführt und in dieser gewendet werden
und wobei die Platten (23) nach dem Wenden unmittelbar von der Wendevorrichtung (16) einer weiteren Behandlungsstation (18) zugeführt werden, wo sie in einem dritten Schritt auf der der im ersten Schritt behandelten Seite entgegengesetzten Seite mit dem flüssigen Medium behandelt werden,
dadurch gekennzeichnet, daß die Platten in beiden Behandlungsstationen jeweils einseitig auf ihrer Unterseite mit dem flüssigen Medium behandelt werden
und daß die Behandlung mit intensivem Flüssigkeitsaustausch durch Düsensysteme (42) mit mehreren in Transportrichtung aufeinanderfolgenden Düsen erfolgt.

2. Verfahren zum Behandeln von plattenförmigen Gegenständen mit einem flüssigen Medium,
wobei die Platten (23) in horizontaler Lage durch eine Behandlungsvorrichtung (10) hindurch transportiert werden,
wobei die Platten (23) in einem ersten Schritt in einer ersten Behandlungsstation (14) auf einer Seite mit dem flüssigen Medium behandelt werden,
wobei die Platten (23) in einem zweiten Schritt horizontal einer Wendevorrichtung (16) zugeführt und in dieser gewendet werden
und wobei die Platten (23) nach dem Wenden unmittelbar von der Wendevorrichtung (16) einer weiteren Behandlungsstation (18) zugeführt werden, wo sie in einem dritten Schritt auf der der im ersten Schritt behandelten Seite entgegengesetzten Seite mit dem flüssigen Medium behandelt werden,
dadurch gekennzeichnet, daß die Platten in beiden Behandlungsstationen jeweils einseitig auf ihrer Unterseite mit dem flüssigen Medium behandelt werden und daß die Behandlung mit intensivem Flüssigkeitsaustausch mittels Schwallstrecke erfolgt und einen Ätzvorgang oder ein Anquellen eines Fotoresists umfaßt.

3. Verfahren nach Anspruch 1 oder 2, dadurch gekennzeichnet, daß als weitere Behandlungsstation die erste Behandlungsstation verwendet wird, wobei die Platten der ersten Behandlungsstation nach dem Wenden in entgegengesetzter Richtung zur allgemeinen Transportrichtung zugeführt werden.

4. Verfahren nach einem der Ansprüche 1 bis 3, dadurch gekennzeichnet, daß die Platten mittels der Wendevorrichtung (16) um eine Achse gedreht werden, welche parallel zur Transportebene angeordnet ist und mit der Transportrichtung einen Winkel von 45° bildet.

5. Verfahren nach einem der Ansprüche 1 bis 4, dadurch gekennzeichnet, daß im ersten und dritten Schritt die jeweils oben liegende Plattenseite im wesentlichen vollständig abgedeckt wird, so daß das flüssige Medium nicht zutreten kann.

6. Verfahren nach einem der Ansprüche 1 bis 5, dadurch gekennzeichnet, daß die Platten beim Transport durch die Behandlungsvorrichtung (10) im Bereich der ersten und der weiteren Behandlungsstation angehalten oder verlangsamt transportiert werden und daß die Platten nach der Behandlung in der ersten und weiteren Behandlungsstation (14, 18) mit der ursprünglichen Geschwindigkeit weitertransportiert werden.

7. Verfahren nach einem der Ansprüche 1 bis 6, dadurch gekennzeichnet, daß das flüssige Medium in Form einer Schwallstrecke und/oder mittels einer Vielzahl von Sprüh- und/oder Vernebelungsdüsen gegen die untenliegende Seite der Platte (23) gefördert wird, wobei vorzugsweise die Fördermittel gegenüber der Platte (23) so bewegt werden, daß eine gleichmäßige Behandlung der im wesentlichen gesamten untenliegenden Seite der Platte erzielt wird.

8. Verfahren nach einem der vorhergehenden Ansprüche, dadurch gekennzeichnet, daß mittels Sensoren (37, 38, 39) die jeweilige Position der Platten auf ihrem Transportweg erfaßt wird.

9. Verfahren nach einem der vorhergehenden Ansprüche, dadurch gekennzeichnet, daß im Bereich der Wendevorrichtung (16) ein Sensor angeordnet wird, der das Eintreten der rückwärtigen Plattenkante in die Wendevorrichtung meldet.

10. Vorrichtung zum Behandeln von plattenförmigen Gegenständen mit einem flüssigen Medium, insbesondere zur Durchführung eines Verfahrens gemäß einem der vorhergehenden Ansprüche mit einer Transportvorrichtung (24, 26) für den horizontalen Transport der Platten (23) durch die Vorrichtung;
mindestens einer Behandlungsstation (14, 18) zur Behandlung einer Seite der Platten (23) mit einem flüssigen Medium;
und mit einer Wendevorrichtung (16) zum Drehen der Platten (23) mit ihrer untenliegenden Seite in die Oberlage,
dadurch gekennzeichnet, daß die Wendevorrichtung (16) eigene, von der Transportvorrichtung (24, 26) unabhängig antreibbare Transportmittel (32) zur Bewegung der Platten in die und aus der Wendevorrichtung (16) umfaßt und daß die durch die Transportvorrichtung und durch die Transportmittel gebildeten Transportebenen unmittelbar und stetig ineinander übergehen und daß beide Behandlungsstationen zur Behandlung der jeweils in ihr untenliegenden Seiten der Platten (23) ausgebildet sind.

11. Vorrichtung nach Anspruch 10, dadurch gekennzeichnet, daß die Transportvorrichtung (24, 26) und die Transportmittel (32) eine gemeinsame Transportebene bilden, und/oder so ausgebildet sind, daß die Platten (23) beim Drehen ortsfest fixiert sind.

12. Vorrichtung nach einem der Ansprüche 10 oder 11, dadurch gekennzeichnet, daß eine Drehachse (46b) für die Drehbewegung der Platten (23) in der Transportebene der Transportmittel und senkrecht zur Transportrichtung oder in einem Winkel von 45° zur Transportrichtung angeordnet ist, wobei ggf. eine Vorrichtung zum Erfassen einer Vorzugsrichtung auf einer Oberfläche der Platten vorhanden ist und daß die Drehachse (46a, b, c) für die Drehbewegung in Abhängigkeit der erfaßten Vorzugsrichtung auswählbar ist.

13. Vorrichtung nach einem der Ansprüche 10 bis 12, dadurch gekennzeichnet, daß die Wendevorrichtung (16) einen Sensor (37) zum Erfassen der rückwärtigen Kante der in die Wendevorrichtung (16) einlaufenden Platte (23) umfaßt.

14. Vorrichtung nach einem der Ansprüche 10 bis 13, dadurch gekennzeichnet, daß die Transportvorrichtung (24, 26) oberhalb der Transportebene wenigstens ein umlaufendes Endlosband (28, 30) umfaßt und daß das Untertrum des Bandes die Oberseite der Platten im wesentlichen vollständig und flüssigkeitsdicht bedeckt und/oder daß die Transportmittel (32) der Wendevorrichtung (16) oberhalb und unterhalb der Transportebene jeweils ein endlos umlaufendes Band (34) umfassen, wobei vorzugsweise jedes Endlosband (28, 30, 34) im wesentlichen die gesamte Arbeitsbreite der Vorrichtung überspannen.

15. Vorrichtung nach einem der Ansprüche 10 bis 14, dadurch gekennzeichnet, daß die oberhalb der Transportebene angeordneten Teile (28, 30) der Transportvorrichtung als Ganzes verschwenkbar an der Vorrichtung gehalten sind, wobei vorteilhaft die Verschwenkachse senkrecht zur Transportvorrichtung und parallel zur Transportebene angeordnet ist.

16. Vorrichtung nach einem der Ansprüche 10 bis 15, dadurch gekennzeichnet, daß die Behandlungsstationen (14, 18) mit dem flüssigen Medium aus einem gemeinsamen Sumpf (40) versorgbar sind.

17. Vorrichtung nach einem der Ansprüche 10 bis 16, dadurch gekennzeichnet, daß wenigstens eine Behandlungsstation (14, 18) einen Düsenstock mit einer Vielzahl von Düsen umfaßt, der vorzugsweise gegenüber den in der Behandlungsstation befindlichen Platten bewegbar ist.

18. Vorrichtung nach einem der Ansprüche 10 bis 17, dadurch gekennzeichnet, daß nachfolgend zur ersten Behandlungsstation (14) unmittelbar die Wendevorrichtung (16) und danach in Transportrichtung unmittelbar anschließend entweder die weitere Behandlungsstation (18) und ein Reinigungs- oder Spülmodul (20) und/oder direkt ein Reinigungs- oder Spülmodul angeordnet sind.

## Claims

1. Process for the treatment of board-like articles with a liquid medium, the boards (23) being conveyed horizontally through a treatment apparatus (10), the boards (23) being treated on one side with the liquid medium in a first stage in a first treatment station (14), then in a second stage the boards (23) are horizontally supplied to a reversing mechanism (16) and are reversed therein and then, after reversal, the boards (23) are supplied directly from the reversing mechanism (16) to a further treatment station (18), where in a third stage they are treated with the liquid medium on the side opposite to that treated in the first stage, characterized in that in both treatment stations the boards are in each case treated on one side of their underside with the liquid medium and that the treatment takes place with intense liquid exchange by nozzle systems (42) with several successive nozzles in the conveying direction.

2. Process for the treatment of board-like articles with a liquid medium, the boards (23) being conveyed horizontally through a treatment apparatus (10), the boards (23) being treated on one side with the liquid medium in a first stage in a first treatment station (14), then in a second stage the boards (23) are horizontally supplied to a reversing mechanism (16) and are reversed therein and then, after reversal, the boards (23) are supplied directly from the reversing mechanism (16) to a further treatment station (18), where in a third stage they are treated with the liquid medium on the side opposite to that treated in the first stage, characterized in that in both treatment stations the boards are in each case treated on one side of their underside with the liquid medium and that the treatment takes place with intense liquid exchange by means of a wave section and includes an etching process or a swelling of a photoresist.

3. Process according to claim 1 or 2, characterized in that as a further treatment station use is made of the first treatment station, the boards being supplied to the first treatment station after reversal in the opposite direction to the general conveying direction.

4. Process according to one of the claims 1 to 3, characterized in that the boards are rotated by means of the reversing mechanism (16) about an axis which is parallel to the conveying plane and forms an angle of 45° with the conveying direction.

5. Process according to one of the claims 1 to 4, characterized in that in the first and third stages the in each case top board side is substantially completely covered, so that the liquid medium has no access thereto.

6. Process according to one of the claims 1 to 5, characterized in that on conveying through the treatment apparatus (10) the boards are stopped or conveyed at a lower speed in the vicinity of the first and further treatment station and that after the boards have been treated in the first and further treatment station (14, 18) they are conveyed on again at the original speed.

7. Process according to one of the claims 1 to 6, characterized in that the liquid medium is conveyed in the form of a wave section and/or by means of a plurality of spraying and/or atomizing nozzles against the bottom side of the board (23) and preferably the supply means are so moved against the board (23) that there is a uniform coating of substantially the entire bottom side of the board.

8. Process according to one of the preceding claims, characterized in that by means of sensors (37, 38, 39) the position of the boards on their conveying path is detected.

9. Process according to one of the preceding claims, characterized in that in the vicinity of the reversing mechanism (16) a sensor is provided, which indicates the entry of the rear board edge into the reversing mechanism.

10. Apparatus for treating plate-like articles with a liquid medium, particularly for performing a process according to one of the preceding claims with a conveying mechanism (24, 26) for the horizontal conveying of the boards (23) through the apparatus, at least one treatment station (14, 18) for treating one side of the boards (23) with a liquid medium and with a reversing mechanism (16) for rotating the boards (23) with their bottom side into the top position, characterized in that the reversing mechanism (16) comprises its own drivable conveying means (32), independent of the conveying mechanism (24, 26), for the movement of the boards into and out of the reversing mechanism (16) and that the conveying planes formed by the conveying mechanism and by the conveying means directly and constantly pass into one another and that both treatment stations are constructed for the treatment of the in each case bottom sides of the boards (23) located therein.

11. Apparatus according to claim 10, characterized in that the conveying mechanism (24, 26) and the conveying means (32) form a common conveying plane and/or are so constructed that the boards (23) are fixed during rotation.

12. Apparatus according to one of the claims 10 or 11, characterized in that a rotation axis (46b) for the rotary movement of the boards (23) is located in the conveying plane of the conveying means and perpendicular to the conveying direction or at an angle of 45° to the conveying direction and optionally there is a device for detecting a preferred direction on the surface of the boards and that the rotation axis (46a, b, c) for the rotary movement can be selected as a function of the detected preferred direction.

13. Apparatus according to one of the claims 10 to 12, characterized in that the reversing mechanism (16) incorporates a sensor (37) for detecting the rear edge of the board (23) entering the reversing mechanism (16).

14. Apparatus according to one of the claims 10 to 13, characterized in that, above the conveying plane, the conveying mechanism (24, 26) comprises at least one revolving endless belt (28, 30) and that the lower strand of the belt covers in substantially complete and liquid-tight manner the top of the boards and/or the conveying means (32) of the reversing mechanism (16) comprise above and below the conveying plane in each case one continuously revolving belt (34) and preferably each endless belt (28, 30, 34) substantially covers the entire working width of the apparatus.

15. Apparatus according to one of the claims 10 to 14, characterized in that the parts (28, 30) of the conveying mechanism as a whole positioned above the conveying plane are held pivotably on the apparatus and advantageously the pivoting axis is perpendicular to the conveying mechanism and parallel to the conveying plane.

16. Apparatus according to one of the claims 10 to 15, characterized in that the treatment stations (14, 18) can be supplied with the liquid medium from a common sump or pool (40).

17. Apparatus according to one of the claims 10 to 16, characterized in that at least one treatment station (14, 18) incorporates a nozzle assembly, which is preferably movable with respect to the boards located in the treatment station.

18. Apparatus according to one of the claims 10 to 17, characterized in that following the first treatment station (14) is directly located the reversing mechanism (16) and then in the conveying direction directly following the same either the further treatment station (18) and/or a cleaning or rinsing module (20) and/or directly a cleaning or rinsing module is provided.

## Revendications

1. Procédé pour le traitement d'objets en forme de plaques à l'aide d'un agent liquide,
dans lequel les plaques (23) sont transportées, en position horizontale, à travers un dispositif de traitement (10),
dans lequel les plaques (23) sont traitées sur une face à l'aide de l'agent liquide, en une première étape, dans un premier poste de traitement (14),
dans lequel, en une deuxième étape, les plaques (23) sont délivrées horizontalement à un dispositif de retournement (16), et sont retournées dans ce dernier,
et dans lequel, à l'issue du retournement, les plaques (23) sont directement délivrées, à partir du dispositif de retournement (16), à un poste supplémentaire de traitement (18) dans lequel elles sont traitées en une troisième étape, à l'aide de l'agent liquide, sur la face opposée à la face traitée lors de la première étape,
caractérisé par le fait que les plaques sont respectivement traitées d'un côté à l'aide de l'agent liquide, dans les deux postes de traitement, sur leur face inférieure ; et par le fait que le traitement a lieu avec échange intensif de liquide, par l'intermédiaire de systèmes (42) à buses qui sont munis de plusieurs buses agencées en succession dans la direction du transport.

2. Procédé pour le traitement d'objets en forme de plaques à l'aide d'un agent liquide,
dans lequel les plaques (23) sont transportées, en position horizontale, à travers un dispositif de traitement (10),
dans lequel les plaques (23) sont traitées sur une face à l'aide de l'agent liquide, en une première étape, dans un premier poste de traitement (14),
dans lequel, en une deuxième étape, les plaques (23) sont délivrées horizontalement à un dispositif de retournement (16), et sont retournées dans ce dernier,
et dans lequel, à l'issue du retournement, les plaques (23) sont directement délivrées, à partir du dispositif de retournement (16), à un poste supplémentaire de traitement (18) dans lequel elles sont traitées en une troisième étape, à l'aide de l'agent liquide, sur la face opposée à la face traitée lors de la première étape,
caractérisé par le fait que les plaques sont respectivement traitées d'un côté à l'aide de l'agent liquide, dans les deux postes de traitement, sur leur face inférieure ; et par le fait que le traitement a lieu avec échange intensif de liquide au moyen d'une piste à pulvérisation continue, et englobe un processus de décapage ou le gonflement d'un agent photorésistif.

3. Procédé selon la revendication 1 ou 2, caractérisé par le fait que le premier poste de traitement est utilisé en tant que poste supplémentaire de traitement, les plaques étant délivrées au premier poste de traitement, à l'issue du retournement, dans une direction opposée à la direction générale du transport.

4. Procédé selon l'une des revendications 1 à 3, caractérisé par le fait que les plaques sont mises en rotation, au moyen du dispositif de retournement (16), autour d'un axe agencé parallèlement au plan du transport et formant un angle de 45° avec la direction du transport.

5. Procédé selon l'une des revendications 1 à 4, caractérisé par le fait que, lors des première et troisième étapes, la face des plaques qui occupe respectivement une position supérieure est, pour l'essentiel, intégralement recouverte de telle sorte que l'agent liquide ne puisse pas parvenir.

6. Procédé selon l'une des revendications 1 à 5, caractérisé par le fait que, au cours du transport à travers le dispositif de traitement (10), les plaques sont stoppées ou transportées avec ralentissement dans la région du premier poste et du poste supplémentaire de traitement ; et par le fait que, à l'issue du traitement dans le premier poste et dans le poste supplémentaire de traitement (14, 18), le transport des plaques se poursuit à la vitesse initiale.

7. Procédé selon l'une des revendications 1 à 6, caractérisé par le fait que l'agent liquide est acheminé, sous la forme d'une piste à pulvérisation continue et/ou au moyen d'un grand nombre de buses de pulvérisation et/ou d'atomisation, vers la face de la plaque (23) qui occupe une position inférieure, les moyens d'acheminement étant de préférence mis en mouvement, par rapport à la plaque (23), de manière à obtenir un traitement uniforme affectant, pour l'essentiel, l'intégralité de la face de ladite plaque qui occupe une position inférieure.

8. Procédé selon l'une des revendications précédentes, caractérisé par le fait que la position considérée des plaques, sur leur trajet de transport, est détectée au moyen de capteurs (37, 38, 39).

9. Procédé selon l'une des revendications précédentes, caractérisé par le fait qu'un capteur, installé dans la région du dispositif de retournement (16), signale la pénétration du bord postérieur des plaques dans ledit dispositif de retournement.

10. Dispositif pour le traitement d'objets en forme de plaques à l'aide d'un agent liquide, notamment pour la mise en oeuvre d'un procédé selon l'une des revendications précédentes, comprenant un dispositif de transport (24, 26) pour le transport horizontal des plaques (23) à travers le dispositif ;
au moins un poste de traitement (14, 18) en vue du traitement d'une face des plaques (23) à l'aide d'un agent liquide ;
et un dispositif de retournement (16) pour amener, par rotation, la face inférieure des plaques (23) à la position supérieure,
caractérisé par le fait que le dispositif de retournement (16) englobe des moyens de transport (32) qui lui sont propres et peuvent être entraînés indépendamment du dispositif de transport (24, 26), en vue de déplacer les plaques jusque dans le dispositif de retournement (16), et hors de ce dernier ; par le fait que les plans de transport, formés par le dispositif de transport et par les moyens de transport, fusionnent mutuellement de façon directe et continue ; et par le fait que les deux postes de traitement sont réalisés en vue du traitement des faces des plaques (23) qui occupent, respectivement, une position inférieure dans lesdits postes.

11. Dispositif selon la revendication 10, caractérisé par le fait que le dispositif de transport (24, 26) et les moyens de transport (32) forment un plan commun de transport, et/ou sont réalisés de telle sorte que les plaques (23) soient consignées fermement à demeure lors de la rotation.

12. Dispositif selon l'une des revendications 10 ou 11, caractérisé par le fait qu'un axe de rotation (46b), destiné au mouvement rotatoire des plaques (23), est disposé dans le plan de transport des moyens de transport et perpendiculairement à la direction du transport, ou selon un angle de 45° par rapport à la direction du transport, un dispositif étant éventuellement présent pour détecter une direction préférentielle sur une surface des plaques ; et par le fait que l'axe de rotation (46a, b, c) destiné au mouvement rotatoire peut être choisi en fonction de la direction préférentielle détectée.

13. Dispositif selon l'une des revendications 10 à 12, caractérisé par le fait que le dispositif de retournement (16) englobe un capteur (37) pour détecter le bord postérieur de la plaque (23) pénétrant dans ledit dispositif de retournement (16).

14. Dispositif selon l'une des revendications 10 à 13, caractérisé par le fait que le dispositif de transport (24, 26) englobe, au-dessus du plan de transport, au moins une bande sans fin (28, 30) tournant en continu ; par le fait que le brin inférieur de la bande recouvre la face supérieure des plaques, pour l'essentiel intégralement et avec étanchéité vis-à-vis du liquide ; et/ou par le fait que les moyens de transport (32) du dispositif de retournement (16) englobent une bande (34), tournant respectivement sans fin au-dessus et au-dessous du plan de transport, chaque bande sans fin (28, 30, 34) coiffant, de préférence, pour l'essentiel toute la largeur de travail du dispositif.

15. Dispositif selon l'une des revendications 10 à 14, caractérisé par le fait que les pièces (28, 30) du dispositif de transport, qui sont situées au-dessus du plan de transport, sont retenues sur le dispositif en pouvant pivoter comme un tout, l'axe de pivotement étant avantageusement agencé perpendiculairement au dispositif de transport, et parallèlement au plan de transport.

16. Dispositif selon l'une des revendications 10 à 15, caractérisé par le fait que les postes de traitement (14, 18) peuvent être alimentés en agent liquide à partir d'un carter commun (40).

17. Dispositif selon l'une des revendications 10 à 16, caractérisé par le fait qu'au moins un poste de traitement (14, 18) englobe une rampe à buses qui est pourvue d'un grand nombre de buses et est mobile, de préférence, par rapport aux plaques situées dans le poste de traitement.

18. Dispositif selon l'une des revendications 10 à 17, caractérisé par le fait que le premier poste de traitement (14) est directement suivi du dispositif de retournement (16) auquel sont (est) directement adjacent(s), dans la direction du transport, le poste supplémentaire de traitement (18) et un module (20) de nettoyage ou de rinçage, et/ou directement un module de nettoyage ou de rinçage.
